# DEMANDE DE BREVET EUROPEEN

(11) **EP 4 576 207 A1**
(43) Date de publication de la demande: **25.06.2025**
(21) Numéro de dépôt: 24221041.7
(22) Date de dépôt: 18.12.2024
(51) Int. Cl.: H01L 23/498

(54) **MODULE ÉLECTRONIQUE, MOULE ASSOCIÉ ET PROCÉDÉ DE FABRICATION D'UN MODULE ÉLECTRONIQUE ASSOCIÉ**

(30) Priorité: 21.12.2023 FR 2314961
(71) Demandeur: Valeo eAutomotive Germany GmbH, 91056 Erlangen (DE)
(72) Inventeur: PIERRE, Thomas, 94046 CRETEIL CEDEX (FR); MASSOL, Laurent, 94046 CRETEIL CEDEX (FR); KOPP, Gabriel, 94046 CRETEIL CEDEX (FR)
(74) Mandataire: Valeo Powertrain Systems

(57) **Abrégé**

L'invention concerne un module électronique (1) comprenant :
une piste de connexion (11) ayant au moins une ouverture (115),
un manchon (12) fixé de façon électriquement conductrice à la piste de connexion (11), ledit manchon (12) comprenant une première extrémité ayant un pied (121) de section de forme complémentaire à celle de l'ouverture (115) dans la piste de connexion (11), ledit pied (121) étant logé dans l'ouverture (115) de la piste de connexion (11).

L'invention concerne également un moule associé et un procédé de fabrication d'un module électronique (1).

## Description

### DOMAINE DE L'INVENTION

La présente invention concerne le domaine de l'électronique de puissance. La présente invention concerne plus particulièrement un module électronique.

L'invention peut trouver son application dans les systèmes électroniques pour onduleurs, par exemple, de traction, dans les chargeurs embarqués, pour pompes électriques de refroidissement, par exemple, de batterie, dans les pompes à chaleur, dans les capteurs laser, par exemple pour conduite autonome, etc.

### ETAT DE LA TECHNIQUE

Il est connu d'utiliser des manchons (ou sleeve selon la terminologie anglosaxonne) afin de maintenir certaines broches électriques des modules électroniques. Les broches électriques sont insérées en force dans les manchons qui permettent ainsi de maintenir en force lesdites broches au-dessus du module électronique.

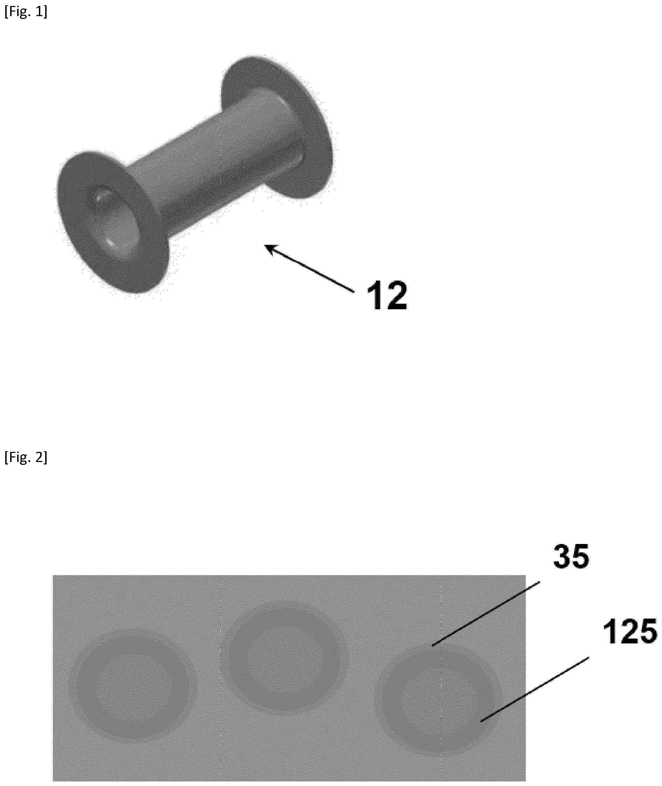

À titre illustratif, la figure 1 représente un exemple de mode de réalisation d'un manchon 12. Dans cet exemple, le manchon 12 est formé d'un tube en matériau électriquement conducteur comme du cuivre dont chaque extrémité est retournée pour former une collerette. Chaque extrémité du manchon 12 est ouverte. Ces manchons sont destinés à être soudés, par exemple sur une piste de connexion (ou « *leadframe* » selon la terminologie anglosaxonne).

Un problème se pose lors du soudage des manchons. En effet, lors de cette opération les manchons sont susceptibles de se déplacer, comme illustré sur la figure 2, entrainant une variation de leur position et donc de la position des broches électriques.

Un but de l'invention est notamment de corriger tout ou partie des inconvénients de l'art antérieur en proposant une solution permettant de réduire les dispersions de position des manchons lors de leur soudure.

### BREVE DESCRIPTION DE L'INVENTION

A cet effet, l'invention a pour objet un module électronique comprenant :
une piste de connexion ayant au moins une ouverture,
un manchon fixé de façon électriquement conductrice à la piste de connexion, ledit manchon comprenant une première extrémité ayant un pied de section de forme complémentaire à celle de l'ouverture dans la piste de connexion, ledit pied étant logé dans l'ouverture de la piste de connexion.

Suivant un mode de réalisation, le manchon est fixé par au moins un moyen pris parmi le collage électriquement conducteur, le soudage ou le brasage.

Suivant un mode de réalisation, le manchon comprend une deuxième extrémité, ladite deuxième extrémité étant déformable par compression.

Suivant un mode de réalisation, le manchon est fixé à la piste de connexion au niveau du pied dudit manchon.

Suivant un mode de réalisation, le manchon comprend une zone de fixation, par exemple, une collerette ou plusieurs pattes, le manchon étant fixé à la piste de connexion par la zone de fixation.

Suivant un mode de réalisation, le manchon comprend une deuxième extrémité, ladite deuxième extrémité du manchon ayant une forme évasée.

Suivant un mode de réalisation, la deuxième extrémité du manchon a une forme hémisphérique.

L'invention a également pour objet un moule configuré pour coopérer avec au moins un manchon d'un module électronique tel que décrit précédemment, ledit moule comprenant au moins une excroissance de forme complémentaire à la forme d'une deuxième extrémité du manchon.

Suivant un mode de réalisation, l'au moins une excroissance à une forme hémisphérique, le diamètre de l'hémisphère de l'excroissance étant supérieur à celui de l'hémisphère du manchon. En variante, le diamètre de l'hémisphère de l'excroissance est inférieur à celui de l'hémisphère du manchon.

Suivant un mode de réalisation, le moule comprend au moins une buse traversante, ladite buse débouchant au niveau de l'au moins une excroissance.

Un troisième objet de l'invention est un procédé de fabrication d'un module électronique comportant les étapes suivantes :
- fournir au moins une piste de connexion ;
- former une ouverture dans la piste de connexion ;
- fournir au moins un manchon ayant une première extrémité comprenant un pied ayant une section de forme complémentaire à celle de l'ouverture dans la piste de connexion ;
- loger le pied du manchon dans l'ouverture de la piste de connexion ;
- fixer le manchon à la piste de connexion par un moyen électriquement conducteur ;

Suivant un mode de mise en oeuvre du procédé, le au moins un manchon comprend une deuxième extrémité déformable par compression, et le procédé comprend en outre les étapes suivantes :
- fournir au moins un moule comprenant au moins une excroissance de forme complémentaire à la forme de la deuxième extrémité du manchon ;
- appliquer le moule, au contact du manchon ;
- déformer, par compression, la deuxième extrémité du manchon à l'aide de l'au moins une excroissance du moule.

Suivant un mode de mise en oeuvre, le procédé comprend en outre l'étape suivante :
- déposer un film, par exemple un film en Fluoropolymères, entre la deuxième extrémité du manchon et l'au moins une excroissance du moule.

Suivant un mode de mise en oeuvre du procédé, l'étape de fixation est réalisée au niveau du pied du manchon.

Suivant un mode de mise en oeuvre du procédé, l'étape de fixation est réalisée au niveau de la zone de fixation du manchon.

Suivant un mode de mise en oeuvre du procédé, l'étape de fixation est réalisée par un moyen pris parmi le brasage, le soudage ou le collage électriquement conducteur.

### BREVE DESCRIPTION DES FIGURES

D'autres particularités et avantages de la présente invention apparaîtront plus clairement à la lecture de la description ci-après, donnée à titre illustratif et non limitatif, et faite en référence aux figures annexées, sur lesquelles :
[Fig.1], précédemment décrite, représente un exemple de mode de réalisation d'un manchon connu de l'art antérieur ;
[Fig.2], précédemment décrite, illustre la dispersion des manchons lors de leur fixation ;
[Fig.3] est une représentation schématique d'un détail, centré autour d'un manchon, d'un mode de réalisation d'un module électronique avant son surmoulage ;
[Fig.4] représente un détail d'un module électronique, selon l'invention, à l'issue de son surmoulage ;
[Fig.5] est un détail, centré autour d'un mode de réalisation particulier d'un manchon, d'une variante de réalisation d'un module électronique, avant son surmoulage ;
[Fig.6] illustre la coopération entre une extrémité d'un manchon et l'excroissance d'un moule en fonction de la hauteur dudit manchon ;
[Fig.7] illustre un problème lié à la dispersion en hauteur de manchons.

Sur les différentes figures, les éléments analogues sont désignés par des références identiques. En outre, les différents éléments ne sont pas nécessairement représentés à l'échelle afin de présenter une vue permettant de faciliter la compréhension de l'invention.

### DESCRIPTION DETAILLEE DE L'INVENTION

Par la suite, on désignera par « *hauteur du manchon* », la distance longitudinale dudit manchon. Il en sera de même pour la « *hauteur du pied d'un manchon »* qui désignera la distance longitudinale du pied du manchon. La « *hauteur de la piste de connexion* » quant à elle, fera référence à la distance selon un axe perpendiculaire à la surface de la piste de connexion.

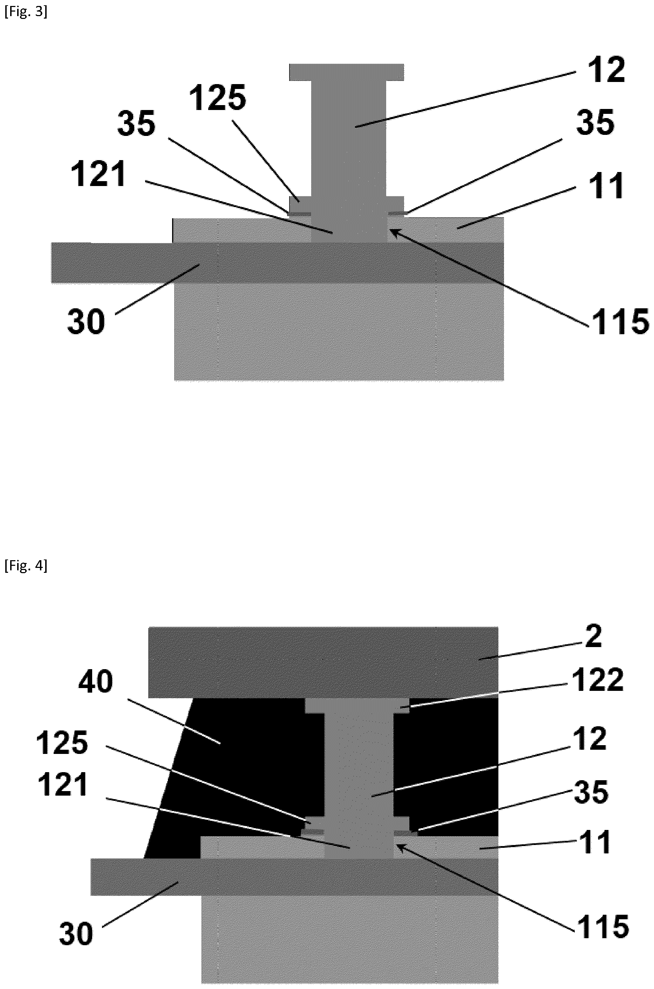

La figure 3 représente d'un détail, centré autour d'un manchon 12, d'un mode de réalisation d'un module électronique 1 selon l'invention avant son surmoulage.

Suivant un mode de réalisation, le module électronique 1 comprend un module de puissance ou un module d'excitation.

Le module électronique 1 comprend au moins une piste de connexion 11 et au moins un manchon 12 fixé de façon électriquement conductrice à la piste de connexion 11.

La piste de connexion 11 peut s'étendre, par exemple, sur un isolant 30.

Le manchon 12 peut être fixé à la piste de connexion par collage à l'aide d'une colle électriquement conductrice. Suivant un autre mode de réalisation, le manchon 12 est soudé ou brasé sur la piste de connexion 11.

Suivant un mode de réalisation, le manchon 12 comprend un pied 121 venant fermer une première extrémité du manchon 12.

Suivant un mode de réalisation, la piste de connexion 11 comprend au moins une ouverture 115 au niveau de l'emplacement d'un manchon 12. Cette ouverture 115 est destinée à recevoir le pied 121 d'un manchon 12. Le pied 121 du manchon 12 possède une section de forme complémentaire à celle de l'ouverture 115 dans la piste de connexion 11.

L'ouverture 115 de la piste de connexion 11 est, par exemple, un trou borgne ou débouchant de forme cylindrique. Dans cet exemple de réalisation, la section du pied 121 du manchon 12 est ronde.

De façon préférentielle, le pied 121 s'étend sur toute la hauteur de la piste de connexion assurant ainsi un bon maintien du manchon 12 dans la piste de connexion 11.

Ainsi, en logeant le pied 121 du manchon 12 dans l'ouverture 115, le manchon est directement ancré et référencé sur la piste de connexion 11. De plus, le fait de loger le pied 121 du manchon dans la piste de connexion 11 permet de maintenir le manchon 12 lors de sa fixation. Cela réduit donc le risque de déplacement du manchon pendant cette opération.

Suivant un mode de réalisation, le manchon 12 est fixé à la piste de connexion au niveau de son pied 121.

Suivant une variante de réalisation, le manchon 12 peut comprendre une zone de fixation 125. Cette zone de fixation 125 est destinée à fixer le manchon à la piste de connexion.

Sur l'exemple de la figure 3, la zone de fixation 125 est une collerette s'étendant sur toute la circonférence du manchon 12. Cette collerette est fixée à l'aide d'un joint de fixation 35, par exemple un joint de brasure, entre la circonférence de collerette et la piste de connexion 11.

. Suivant un autre mode de réalisation, la zone de fixation 125 peut prendre la forme d'au moins une patte de fixation située sur le pourtour du manchon 12. La zone de fixation 125 peut être formée par deux pattes de fixation diamétralement opposées.

Le manchon 12 est destiné à recevoir une broche de connexion électrique (non représentée). La broche de connexion électrique est insérée de force par l'extrémité opposée à la première extrémité possédant le pied 121 du manchon 12. Après son insertion dans le manchon 12, la broche de connexion électrique est en contact électrique avec le manchon 12 qui lui-même est en contact électrique avec la piste de connexion 11.

De façon avantageuse, la présence d'un pied 121 venant fermer l'extrémité du manchon 12, destinée à être fixée à la piste de connexion 11, permet d'éviter toute entrée de soudure à l'intérieur du manchon. En effet, lors de l'étape de soudage du manchon 12, un joint de soudure est déposé sur la circonférence extérieure de la collerette. Il existe donc un risque que de la soudure vienne pénétrer à l'intérieur de l'extrémité du manchon et ainsi l'obstruer, empêchant ainsi l'insertion d'une broche de connexion électrique.

En référence à la figure 4, à l'issue de l'assemblage des éléments du module électronique 1, un moule 2 est appliqué sur l'ensemble. De la résine époxy 40 est ensuite injectée afin de surmouler le module électronique 1. Le moule 2 est configuré pour coopérer avec au moins un manchon 12 du module électronique 1 et plus particulièrement une deuxième extrémité 122 dudit au moins un manchon 12.

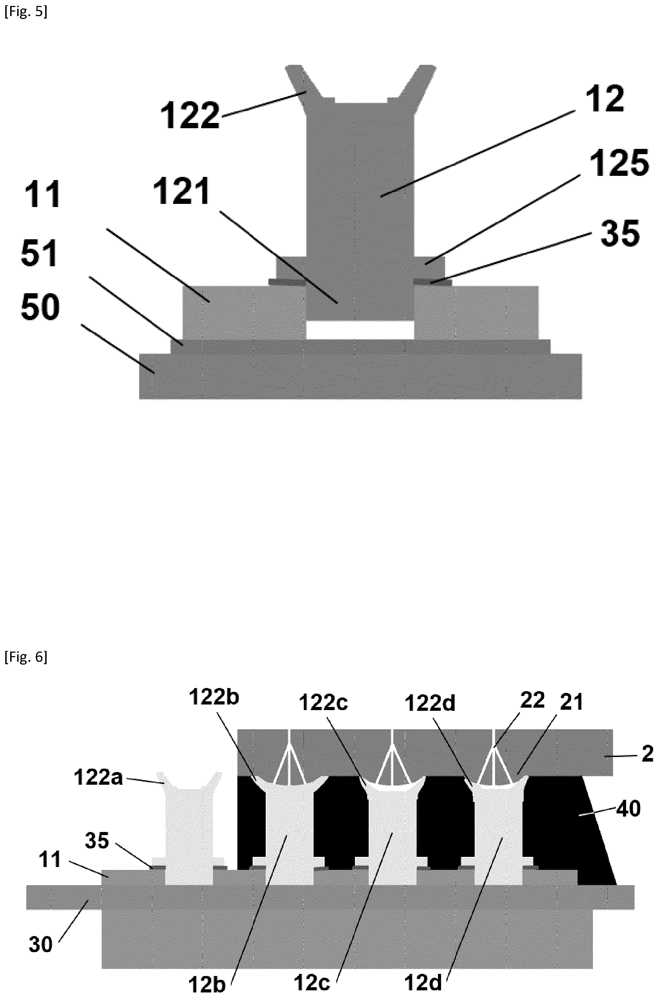

La figure 5 représente, avant son surmoulage, un détail, centré autour d'un manchon 12, d'une variante de réalisation d'un module électronique 1 selon l'invention. Dans cet exemple, le manchon 12 est fixé sur une piste de connexion 11 moulée par transfert (ou TML pour « *Transfer Molded Leadframe* » selon la terminologie anglosaxonne).

Dans ce mode de réalisation, le manchon 12 est fixé entre deux plaques électriquement conductrices et au même potentiel électrique de la piste de connexion 11. Il peut s'agir, par exemple, de deux plaques de cuivre. Ces deux plaques électriquement conductrices sont en contact avec un dissipateur thermique 50 par l'intermédiaire d'une couche 51 de graisse thermique ou de colle thermique.

Le manchon 12 est, par exemple, fixé à la piste de connexion 11 par l'intermédiaire d'un joint de fixation 35, comme un joint de colle électriquement conductrice, entre deux pattes de fixation diamétralement opposée et la piste de connexion 11.

Dans ce mode de réalisation, le pied du manchon 12 possède une hauteur inférieure à la hauteur de la piste de connexion 11.

La figure 5 représente également un mode de réalisation particulier d'un manchon 12 selon l'invention. Dans cet exemple, la partie intérieure la deuxième extrémité 122 du manchon 12, c'est-à-dire l'extrémité opposée à la première extrémité possédant un pied 121, a une forme évasée.

Suivant un mode de réalisation particulier, la partie 'intérieure de la deuxième extrémité 122 du manchon 12 est de forme hémisphérique.

Suivant une variante de réalisation, la deuxième extrémité 122 du manchon 12 est déformable par compression.

En référence à la figure 6, l'invention concerne également un moule 2 configuré pour coopérer avec au moins un manchon 12 du module électronique 1 et plus particulièrement avec l'intérieur de sa deuxième extrémité 122.

Dans le mode de réalisation illustré sur cette figure, le moule 2 comprend au moins une excroissance 21. Cette excroissance 21 possède une forme complémentaire à la forme de la partie intérieure de la deuxième extrémité du au moins un manchon 12 avec laquelle l'excroissance 21 va coopérer.

Suivant un mode de réalisation, le moule 2 possède au moins une excroissance 21 de forme hémisphérique. De même, la partie intérieure de la deuxième extrémité 122 du manchon 12 avec laquelle l'excroissance 21 va coopérer possède une forme évasée hémisphérique. Suivant une particularité de l'invention, le diamètre de l'hémisphère de l'excroissance 21 est supérieur à celui de l'hémisphère de la partie intérieure de la deuxième extrémité 122 du manchon 12 avec laquelle l'excroissance 21 va coopérer.

Suivant un mode de réalisation, le moule comprend au moins une buse 22 traversante et débouchant au niveau de l'au moins une excroissance 21 du moule 2.

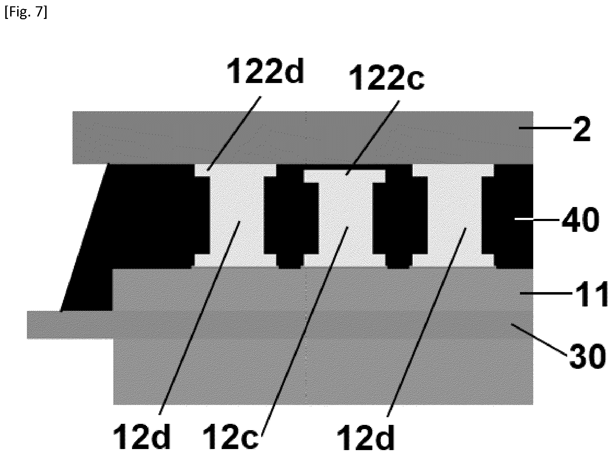

De façon avantageuse, la forme évasée et le caractère déformable de la deuxième extrémité 122 du manchon 12 en coopération avec une excroissance 21 de forme complémentaire du moule 2 permettent de compenser les dispersions en hauteur des manchons 12. Cela sera mieux compris en référence aux figures 6 et 7. Ces figures représentent un détail d'un module électronique 1, à l'issue de son surmoulage, centré autour de manchons 12a, 12b, 12c, 12d de hauteur différente.

Dans l'exemple de la figure 7, un manchon 12c possède une hauteur inférieure à celles des autres manchons 12d. Lorsqu'un moule 2 est appliqué au contact de la deuxième extrémité 122d des manchons 12d, la deuxième extrémité 122c du manchon 12c n'est pas en contact avec le moule 2. Il existe donc un espace libre entre ladite deuxième extrémité 122c, qui est ouverte, et le moule 2. Ainsi, lors de l'étape de surmoulage, par exemple par injection de résine époxy, de la résine est susceptible de pénétrer à l'intérieur du manchon 12c et donc de l'obstruer. Par la suite, l'introduction d'une broche de connexion électrique sera rendu impossible

La figure 6 illustre la coopération entre la partie intérieure de la deuxième extrémité 122b, 122c, 122d d'un manchon 12b, 12c, 12d et l'excroissance d'un moule 2 en fonction de la hauteur dudit manchon. Dans cet exemple, la partie intérieure des deuxièmes extrémités 122a, 122b, 122c, 122d des manchons 12a, 12b, 12c, 12d ont une forme hémisphérique et sont déformables par compression. Les excroissances 21 du moule 2 ont une également forme hémisphérique.

La deuxième extrémité 122a du manchon 12a n'est pas en contact avec le moule 2. Ce manchon permet de visualiser la forme de la deuxième extrémité122a avant compression.

On considère que le manchon 12d possède la bonne hauteur. Sa deuxième extrémité 122d coopère parfaitement avec l'excroissance 21 du moule 2. Le moule 2 obstrue donc correctement la deuxième extrémité 122d du manchon 12d empêchant ainsi toute résine de pénétrer à l'intérieur du manchon 12d lors de l'étape d'injection de résine.

Le manchon 12c possède une hauteur inférieure à la valeur normale. Lorsque l'excroissance 21 du moule 2 vient en contact avec la deuxième extrémité 122c de ce manchon 12c, ces deux éléments ne coopèrent pas parfaitement. Toutefois, l'excroissance 21 du moule 2 comprime légèrement la deuxième extrémité 122c du manchon 12c assurant ainsi la fermeture de la deuxième extrémité 122c. Cela évite ainsi toute intrusion de résine dans le manchon 12c lors de l'étape de surmoulage.

Le manchon 12b possède une hauteur supérieure à la valeur normale. Lorsque l'excroissance 21 du moule 2 vient en contact avec la deuxième extrémité 122c de ce manchon 12c, ces deux éléments coopèrent de façon extrême. L'excroissance 21 du moule 2 comprime complètement la deuxième extrémité 122c du manchon 12c. La souplesse de la deuxième extrémité 122b permet de ne pas bloquer le moule 2 et lui permet de se positionner correctement par rapport aux autres manchons. Cette souplesse permet également à l'excroissance 21 du moule 2 de fermer la deuxième extrémité 122b. Ainsi, même si le manchon possède une hauteur supérieure à la normale, l'intrusion de résine dans ce manchon 12b est évitée.

L'invention concerne également un procédé de fabrication d'un module électronique 1 tel que décrit précédemment. Le procédé comporte les étapes suivantes :
- fournir au moins une piste de connexion 11 ;
- former une ouverture 115 dans la piste de connexion 11 ;
- fournir au moins un manchon 12 ayant une première extrémité comprenant un pied 121, ledit pied ayant une section de forme complémentaire à celle de le section de l'ouverture 115 dans la piste de connexion 11 ;
- loger le pied 121 du manchon 12 dans l'ouverture 115 de la piste de connexion 11 ;
- fixer le manchon 12 à la piste de connexion 11 par un moyen électriquement conducteur.

Suivant un mode de mise en oeuvre du procédé, l'ouverture 115 peut être un trou circulaire. Dans ce cas de figure, la section du pied 121 du manchon 12 est également circulaire.

L'ouverture 115 peut être réalisée par un procédé d'attaque chimique de la piste de connexion 11.

Suivant un mode de mise en oeuvre, l'étape de fixation du pied 121 dans la piste de connexion 11 peut être réalisée par collage électriquement conducteur, par soudage ou par brasage.

Suivant un mode de mise en oeuvre, l'étape de fixation du pied 121 dans la piste de connexion 11 est réalisée au niveau du pied 121 du manchon 12.

Suivant une variante de mise en oeuvre, l'étape de fixation du pied 121 dans la piste de connexion 11 est réalisée au niveau de la zone de fixation 125 du manchon 12.

Suivant un mode de mise en oeuvre du procédé, lors de l'étape de fourniture d'au moins un manchon 12, ledit au moins un manchon 12 comprend une deuxième extrémité 122 déformable par compression. Le procédé comprend en outre les étapes suivantes :
- fournir au moins un moule 2 comprenant au moins une excroissance 21 de forme complémentaire à la forme de la deuxième extrémité 122 de l'au moins un manchon 12;
- appliquer le moule 2, au contact de la deuxième extrémité 122 de l'au moins un manchon 12 ;
- déformer, par compression, la deuxième extrémité 122 de l'au moins un manchon 12 à l'aide de l'au moins une excroissance 21 du moule 2.

Selon un mode de mise en oeuvre, le procédé, comprend en outre une étape de dépose d'un film entre la deuxième extrémité 122 de l'au moins un manchon 12 et l'au moins une excroissance 21 du moule 2.

Suivant un mode de mise en oeuvre, le film est un film en Fluoropolymères.

Suivant un mode de mise en oeuvre, le procédé comprend une étape de surmoulage pendant laquelle de la résine, par exemple époxy est injectée sur les différents élément du module électronique 1, après l'application du moule 2 au contact de la deuxième extrémité 122 de l'au moins un manchon 12.

Suivant un mode de mise en oeuvre, le procédé comprend une étape de polymérisation de la résine de surmoulage.

L'invention a été décrite ci-dessus avec l'aide de modes de réalisations présentés sur les figures, sans limitation du concept inventif général.

Bien d'autres modifications et variations se suggèrent d'elles-mêmes à l'homme du métier, après réflexion sur les différents modes de réalisations illustrés dans cette demande.

Ces modes de réalisation sont donnés à titre d'exemple et ne sont pas destinés à limiter la portée de l'invention, qui est déterminée exclusivement par les revendications ci-dessous.

Dans les revendications, le mot « comprenant » n'exclut pas d'autres éléments ou étapes.

Le simple fait que différentes caractéristiques sont énumérées en revendications mutuellement dépendantes n'indique pas qu'une combinaison de ces caractéristiques ne puisse être avantageusement utilisée. Enfin, toute référence utilisée dans les revendications ne doit pas être interprétée comme une limitation de la portée de l'invention.

## Revendications

1. Module électronique (1) comprenant :
une piste de connexion (11) ayant au moins une ouverture (115),
un manchon (12) fixé de façon électriquement conductrice à la piste de connexion (11), ledit manchon (12) comprenant une première extrémité ayant un pied (121) de section de forme complémentaire à celle de l'ouverture () dans la piste de connexion (11), ledit pied (121) étant logé dans l'ouverture () de la piste de connexion (11).

2. Module électronique (1) selon la revendication précédente, dans lequel ledit manchon (12) comprend une deuxième extrémité (122), ladite deuxième extrémité (122) étant déformable par compression.

3. Module électronique (1) selon l'une des revendications 1 ou 2, dans lequel le manchon (12) est fixé à la piste de connexion (11) au niveau du pied (121) dudit manchon (12).

4. Module électronique (1) selon l'une des revendications précédentes, dans lequel le manchon (12) comprend une zone de fixation (125), par exemple, une collerette ou plusieurs pattes, le manchon (12) étant fixé à la piste de connexion (11) par la zone de fixation (125).

5. Module électronique (1) selon l'une des revendications précédentes, dans lequel ledit manchon (12) comprend une deuxième extrémité (122), ladite deuxième extrémité (122) du manchon (12) ayant une forme évasée.

6. Moule (2) configuré pour coopérer avec au moins un manchon (12) d'un module électronique (1) selon l'une des revendications précédentes, ledit moule (2) étant **caractérisé en ce qu'**il comprend au moins une excroissance (21) de forme complémentaire à la forme d'une deuxième extrémité (122) du manchon (12).

7. Moule (2) selon la revendication précédente comprenant au moins une buse (22) traversante, ladite buse (22) débouchant au niveau de l'au moins une excroissance (21).

8. Procédé de fabrication d'un module électronique (1) comportant les étapes suivantes :
- fournir au moins une piste de connexion (11) ;
- former une ouverture (115) dans la piste de connexion (11) ;
- fournir au moins un manchon (12) ayant une première extrémité comprenant un pied (121) ayant une section de forme complémentaire à celle de l'ouverture (115) dans la piste de connexion (11) ;
- loger le pied (121) du manchon (12) dans l'ouverture (115) de la piste de connexion (11) ;
- fixer le manchon (12) à la piste de connexion (11) par un moyen
électriquement conducteur ;

9. Procédé selon la revendication précédente, dans lequel le au moins un manchon (12) comprend une deuxième extrémité (122), ladite deuxième extrémité (122) étant déformable par compression, et le procédé comprenant en outre les étapes suivantes :
- fournir au moins un moule (2) comprenant au moins une excroissance (21) de forme complémentaire à la forme de la deuxième extrémité (122) du manchon (12);
- appliquer le moule (2), au contact du manchon (12) ;
- déformer, par compression, la deuxième extrémité (122) du manchon (12) à l'aide de l'au moins une excroissance (21) du moule (2).

10. Procédé selon la revendication précédente comprenant en outre l'étape suivante :
déposer un film (), par exemple un film en Fluoropolymères, entre la deuxième extrémité (122) du manchon (12) et l'au moins une excroissance (21) du moule (2).
